# DEMANDE DE BREVET EUROPEEN

(11) **EP 3 503 103 A1**
(43) Date de publication de la demande: **26.06.2019**
(21) Numéro de dépôt: 18213223.3
(22) Date de dépôt: 17.12.2018
(51) Int. Cl.: G11C 7/10

(54) **SYSTÈME COMPORTANT UNE MÉMOIRE ADAPTÉE À METTRE EN OEUVRE DES OPÉRATIONS DE CALCUL**

(30) Priorité: 19.12.2017 FR 1762468
(71) Demandeur: Commissariat à l'Energie Atomique et aux Energies Alternatives, 75015 Paris (FR)
(72) Inventeur: CHARLES, Henri-Pierre, 38000 GRENOBLE (FR); KOOLI, Maha, 38100 GRENOBLE (FR); NOEL, Jean-Philippe, 38320 EYBENS (FR)
(74) Mandataire: Cabinet Beaumont

(57) **Abrégé**

L'invention concerne un circuit mémoire (550) comportant :
plusieurs cellules élémentaires de stockage agencées en matrice selon des rangées et des colonnes ;
un port d'entrée/sortie de données (552) ;
un port d'entrée d'adresses (554) ;
un port d'entrée de sélection de mode (558) ; et
un circuit interne de commande configuré pour :
lire un signal de sélection de mode appliqué sur le port de sélection de mode (558) ;
lorsque le signal de sélection de mode est à un premier état, lire une adresse d'une rangée sur le port d'entrée d'adresses (554) et mettre en oeuvre une opération de lecture ou d'écriture dans cette rangée ; et
lorsque le signal de sélection de mode est à un deuxième état, lire sur le port d'entrée/sortie de données (552) un signal d'instruction et mettre en oeuvre une opération comprenant l'activation simultanée en lecture ou en écriture d'au moins deux rangées.

## Description

### Domaine

La présente demande concerne le domaine des circuits mémoire. Elle vise plus particulièrement un circuit mémoire adapté à mettre en oeuvre des opérations de calcul. Elle vise en outre un système comportant un circuit mémoire adapté à mettre en oeuvre des opérations de calcul et un microprocesseur couplé à ce circuit mémoire.

### Exposé de l'art antérieur

Il a déjà été proposé, dans la demande de brevet français N°16/54623 (DD16812/B14843) déposée par le demandeur le 24 mai 2016, un circuit mémoire adapté non seulement à stocker des données, mais aussi à effectuer, in-situ, lors d'accès au contenu de la mémoire, un certain nombre d'opérations logiques et/ou arithmétiques ayant pour opérandes des données stockées dans la mémoire. Ce circuit comprend, comme dans un circuit mémoire classique, une pluralité de cellules élémentaires agencées en matrice selon des rangées et des colonnes, et un circuit de contrôle adapté à mettre en oeuvre des opérations de lecture ou d'écriture de données dans des rangées de la matrice. A la différence d'un circuit mémoire classique dans lequel une seule rangée de la matrice peut être sélectionnée à la fois lors d'une opération de lecture, le circuit de contrôle est adapté à sélectionner simultanément en lecture une pluralité de rangées de la matrice de façon à réaliser une opération logique ayant pour opérandes des données contenues dans les rangées sélectionnées.

La présente demande concerne la problématique de la commande d'un tel circuit mémoire, et, plus particulièrement, de la coopération entre un tel circuit mémoire et un microprocesseur couplé à ce circuit mémoire, notamment pour permettre une utilisation du circuit mémoire à la fois comme mémoire conventionnelle, et comme circuit mémoire intelligente pour mettre en oeuvre des opérations de calcul.

### Résumé

Ainsi, un mode de réalisation prévoit un circuit mémoire comportant :
une pluralité de cellules élémentaires de stockage agencées en matrice selon des rangées et des colonnes ;
un port d'entrée/sortie de données ;
un port d'entrée d'adresses ;
un port d'entrée de sélection de mode ; et
un circuit interne de commande configuré pour :
   lire un signal de sélection de mode appliqué sur le port de sélection de mode ;
   lorsque le signal de sélection de mode est à un premier état, lire une adresse d'une rangée sur le port d'entrée d'adresses et mettre en oeuvre, via le port d'entrée/sortie de données, une opération de lecture ou d'écriture dans cette rangée ; et
   lorsque le signal de sélection de mode est à un deuxième état, lire sur le port d'entrée/sortie de données un signal d'instruction et mettre en oeuvre une opération comprenant l'activation simultanée en lecture ou en écriture d'au moins deux rangées sélectionnées en fonction du signal d'instruction.

Selon un mode de réalisation, le circuit interne de commande est adapté à, lorsque le signal de sélection de mode est au deuxième état, mettre en oeuvre une opération de calcul comprenant l'activation simultanée en lecture d'au moins deux rangées sélectionnées en fonction du signal d'instruction.

Selon un mode de réalisation, le circuit interne de commande est en outre configuré pour, lorsque le signal de sélection de mode est au deuxième état, lire un signal d'adresse sur le port d'entrée d'adresses et écrire à l'adresse correspondante du circuit mémoire un résultat de l'opération de calcul.

Selon un mode de réalisation, le circuit interne de commande est adapté à, lorsque le signal de sélection de mode est au deuxième état, mettre en oeuvre une opération d'écriture d'une même donnée dans au moins deux rangées sélectionnées en fonction du signal d'instruction.

Selon un mode de réalisation, le signal d'instruction comprend un premier champ définissant un type d'opération à mettre en oeuvre, et un deuxième champ définissant les adresses des rangées à sélectionner pour la mise en oeuvre de l'opération.

Selon un mode de réalisation, le deuxième champ comprend un premier sous-champ et un deuxième sous-champ de log₂(N) bits chacun, où N est un entier désignant le nombre de rangées de la matrice.

Selon un mode de réalisation, le circuit de commande interne comprend un circuit de sélection de rangées adapté à générer un vecteur de sélection de rangées de N bits à partir des premier et deuxième sous-champs du deuxième champ du signal d'instruction.

Selon un mode de réalisation, le circuit de sélection de rangées comprend Q=log₂(N) étages Eⱼ, avec j entier allant de 0 à Q-1, chaque étage Eⱼ comprenant une première cellule logique de sélection comprenant des premier et deuxième noeuds d'entrée et des premier et deuxième noeuds de sortie, et 2^{j} deuxièmes cellules logiques de sélection comprenant chacune des premier, deuxième et troisième noeuds d'entrée et des premier et deuxième noeuds de sortie.

Selon un mode de réalisation :
dans chaque étage Eⱼ, chaque deuxième cellule de l'étage a ses deuxième et troisième noeuds d'entrée connectés respectivement aux premier et deuxième noeuds de sortie de la première cellule de l'étage ; et
dans chaque étage Eⱼ à l'exception de l'étage E_{Q-1}, chaque deuxième cellule de l'étage a son premier noeud de sortie connecté au premier noeud d'entrée de l'une des deuxièmes cellules de l'étage Eⱼ₊₁ et son deuxième noeud de sortie connecté au premier noeud d'entrée d'une autre des deuxièmes cellules de l'étage Eⱼ₊₁.

Selon un mode de réalisation :
chaque première cellule comprend des première et deuxième portes logiques OU, la première porte OU ayant une première entrée connectée au premier noeud d'entrée de la cellule, une deuxième entrée connectée au deuxième noeud d'entrée de la cellule, et une sortie connectée au premier noeud de sortie de la cellule, et la deuxième porte OU ayant une première entrée connecté au premier noeud d'entrée de la cellule, une deuxième entrée reliée au deuxième noeud d'entrée de la cellule par l'intermédiaire d'un inverseur, et une sortie connectée au deuxième noeud de sortie de la cellule ; et
chaque deuxième cellule comprend des première et deuxième portes logiques ET, la première porte ET ayant une première entrée connectée au premier noeud d'entrée de la cellule, une deuxième entrée connectée au deuxième noeud d'entrée de la cellule, et une sortie connectée au premier noeud de sortie de la cellule, et la deuxième porte ET ayant une première entrée connectée au premier noeud d'entrée de la cellule, une deuxième entrée connectée au troisième noeud d'entrée de la cellule, et une sortie connectée au deuxième noeud de sortie de la cellule.

Selon un mode de réalisation, le circuit interne de commande est configuré pour, lorsque le signal de sélection de mode est au deuxième état, appliquer les log₂(N) bits du premier sous-champ respectivement sur les log₂(N) deuxièmes noeuds d'entrée des premières cellules du circuit de sélection de rangées, et appliquer les log2(N) bits du deuxième sous-champ respectivement sur les log₂(N) premiers noeuds d'entrée des premières cellules du circuit de sélection de rangées.

Un autre mode de réalisation prévoit un système comportant un microprocesseur et un circuit mémoire tel que défini ci-dessus, le système comportant en outre :
un bus de données reliant un port d'entrée/sortie de données du microprocesseur au port d'entrée/sortie de données du circuit mémoire ;
un bus d'adresses reliant un port de sortie d'adresses du microprocesseur au port d'entrée d'adresses du circuit mémoire ; et
un bus de sélection de mode reliant un port de sortie de sélection de mode du microprocesseur au port d'entrée de sélection de mode du circuit mémoire.

Selon un mode de réalisation, le microprocesseur est configuré pour :
dans un premier mode de fonctionnement :
   - appliquer un signal de sélection de mode au premier état sur le bus de sélection de mode ;
   - appliquer un signal d'adresse de rangée sur le bus d'adresses ; et
   - lire ou écrire une donnée dans la rangée correspondante du circuit mémoire via le bus de données, et
dans un deuxième mode de fonctionnement :
   - appliquer un signal de sélection de mode au deuxième état sur le bus de sélection de mode ; et
appliquer un signal d'instruction sur le bus de données.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique simplifié d'un système comportant un microprocesseur et un circuit mémoire ;
la figure 2 est un diagramme illustrant un exemple de mise en oeuvre d'une opération de calcul conventionnelle dans le système de la figure 1 ;
la figure 3 est un diagramme illustrant un exemple de mise en oeuvre d'une opération de stockage et de lecture conventionnelle dans le système de la figure 1 ;
la figure 4 est un schéma bloc simplifié d'un exemple d'un mode de réalisation d'un circuit mémoire adapté à mettre en oeuvre des opérations de calcul ;
la figure 5 est un schéma électrique simplifié d'un exemple d'un mode de réalisation d'un système comportant un microprocesseur et un circuit mémoire adapté à mettre en oeuvre des opérations de calcul ;
la figure 6 illustre schématiquement un exemple de format d'un signal d'instruction utilisé par le microprocesseur pour commander le circuit mémoire dans le système de la figure 5 ;
la figure 7 est un schéma électrique simplifié d'un exemple d'un circuit de sélection de rangées d'un circuit mémoire adapté à mettre en oeuvre des opérations de calcul ; et
la figure 8 illustre plus en détail un exemple de réalisation de cellules de sélection élémentaires du circuit de sélection de rangées de la figure 8.

### Description détaillée

De mêmes éléments ont été désignés par de mêmes références dans les différentes figures. Par souci de clarté, seuls les éléments utiles à la compréhension des modes de réalisation décrits ont été représentés et sont détaillés. En particulier, la réalisation complète d'un circuit mémoire adapté à mettre en oeuvre des opérations de calcul par activation simultanée en lecture d'une pluralité de rangées d'une matrice de cellules élémentaires n'a pas été détaillée, les modes de réalisation décrits étant compatibles avec les architectures connues de tels circuits, et notamment celles décrites dans la demande de brevet français N°16/54623 susmentionnée. On s'intéresse ici plus particulièrement aux moyens de communication entre le circuit mémoire et un microprocesseur externe au circuit mémoire. Dans la présente description, on utilise le terme "connecté" pour désigner une liaison électrique directe, sans composant électronique intermédiaire, par exemple au moyen d'une ou plusieurs pistes conductrices, et le terme "couplé" ou le terme "relié", pour désigner une liaison qui peut être directe (signifiant alors "connecté") ou qui peut être réalisée par l'intermédiaire d'un ou plusieurs composants.

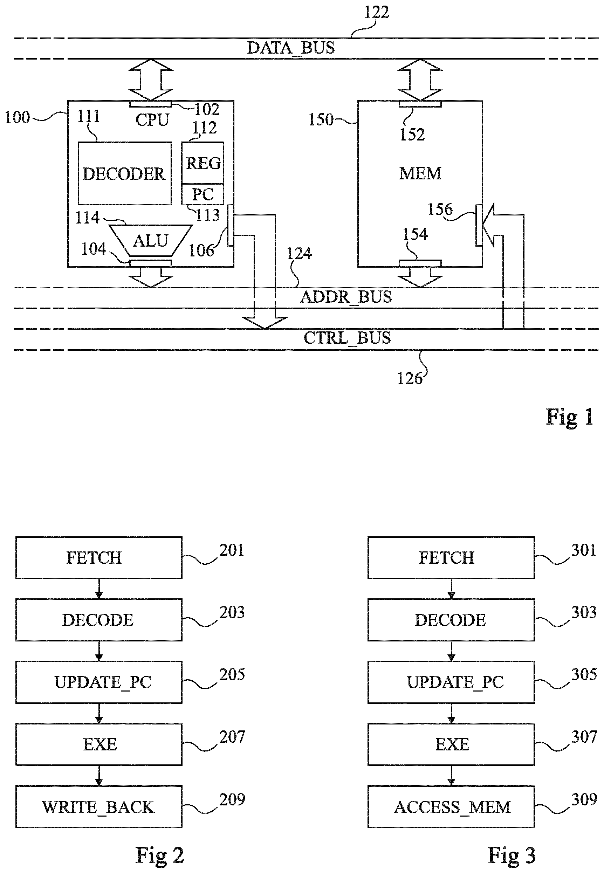

La figure 1 est un schéma électrique simplifié d'un exemple d'un système comportant un microprocesseur 100 (CPU) et un circuit mémoire 150 (MEM) classique.

Dans cet exemple, le système comprend un bus de données 122 (DATA BUS) qui relie, par exemple connecte, un port d'entrée/sortie de données 102 du microprocesseur 100 à un port d'entrée/sortie de données correspondant 152 du circuit mémoire 150.

Le système comprend de plus un bus d'adresses 124 (ADDR_BUS) qui relie, par exemple connecte, un port de sortie d'adresses 104 du microprocesseur 100 à un port d'entrée d'adresses correspondant 154 du circuit mémoire 150.

Le système comprend en outre un bus de contrôle 126 (CTRL_BUS) qui relie, par exemple connecte, un port de sortie de contrôle 106 du microprocesseur 100 à un port d'entrée de contrôle correspondant 156 du circuit mémoire 150. Le bus de contrôle 126 permet notamment d'activer le circuit mémoire en lecture ou en écriture.

Par port d'entrée et/ou de sortie, on entend ici un ensemble d'une ou plusieurs bornes conductrices d'entrée et/ou de sortie destiné à recevoir et/ou à fournir un signal numérique sur un ou plusieurs bits. De plus, on entend par bus un ensemble d'un ou plusieurs éléments conducteurs, par exemple une ou plusieurs pistes conductrices ou un ou plusieurs fils conducteurs, reliant respectivement la ou les bornes d'un port du microprocesseur à la ou les bornes correspondantes d'un port de la mémoire, et destiné à transporter un signal numérique sur un ou plusieurs bits du microprocesseur à la mémoire ou inversement.

En pratique, les bus et ports de données et d'adresses sont adaptés à transmettre des signaux de plusieurs bits en parallèle, par exemple 8 à 64 bits pour le bus de données et 20 à 60 bits pour le bus d'adresses, c'est-à-dire qu'ils comprennent chacun plusieurs conducteurs parallèles. Le bus et le port de contrôle peuvent quant à eux, selon les architectures, comporter un unique conducteur (permettant de transmettre un signal binaire unique), ou plusieurs conducteurs parallèles (permettant de transmettre un signal de plusieurs bits en parallèle).

Pour lire une donnée dans le circuit mémoire 150, le microprocesseur 100 applique l'adresse de la donnée à lire sur le port d'entrée d'adresses 154 du circuit mémoire (via le port de sortie d'adresses 104 du microprocesseur et le bus d'adresses 124), et applique un signal de commande en lecture sur le port d'entrée de contrôle 156 du circuit mémoire (via le port de sortie de contrôle 106 du microprocesseur et le bus de contrôle 126). Le microprocesseur lit ensuite la donnée correspondante sur le port d'entrée/sortie de données 152 du circuit mémoire (via le bus de données 122 et le port d'entrée/sortie de données 102 du microprocesseur).

Pour écrire une donnée dans le circuit mémoire 150, le microprocesseur 100 applique l'adresse de la zone mémoire à écrire sur le port d'entrée d'adresses 154 du circuit mémoire (via le port de sortie d'adresses 104 du microprocesseur et le bus d'adresses 124), applique la donnée à écrire sur le port d'entrée/sortie de données 152 du circuit mémoire (via le port d'entrée/sortie de données 102 du microprocesseur et le bus de données 122), et applique un signal de commande en écriture sur le port d'entrée de contrôle 156 du circuit mémoire (via le port de sortie de contrôle 106 du microprocesseur et le bus de contrôle 126) .

Le microprocesseur 100 est adapté à exécuter une suite d'instructions mémorisée dans une partie spécifique de stockage d'instructions du circuit mémoire 150, par exemple en vue de réaliser des opérations de traitement de données mémorisées dans une autre partie du circuit mémoire 150 ou dans un autre circuit mémoire (non représenté) relié aux mêmes bus d'adresses, de données et de contrôle que le circuit mémoire 150.

Pour cela, dans l'exemple de la figure 1, le microprocesseur comprend un circuit de décodage d'instructions 111 (DECODER), un circuit mémoire interne 112 (REG) comprenant ou plusieurs registres de stockage temporaire de données, un compteur d'instructions 113 (PC), et une unité arithmétique et logique 114 (ALU) adaptée à mettre en oeuvre des opérations arithmétiques et/ou logiques de base pour traiter des données contenues dans le circuit mémoire interne 112. A chaque nouvelle instruction, le compteur d'instructions 113 est incrémenté. Chaque instruction est lue à l'adresse correspondante du circuit mémoire 150, déterminée en fonction de l'état du compteur d'instructions 113. L'instruction est ensuite décodée par le circuit de décodage d'instructions 111 du microprocesseur, puis exécutée par le microprocesseur, étant entendu que l'exécution de l'instruction peut ou non comprendre un accès en lecture ou en écriture au circuit mémoire 150.

La figure 2 est un diagramme illustrant un exemple de procédé de mise en oeuvre d'une opération de calcul dans le système de la figure 1. Plus particulièrement, on considère dans cet exemple que le circuit mémoire interne 112 du microprocesseur 100 comprend deux registres de stockage de données r0 et r1 (non détaillés sur la figure 1), et on considère à titre illustratif la mise en oeuvre d'une instruction de calcul de type "add r0, r1, CST" (en langage assembleur), consistant à additionner au contenu du registre r1 la valeur constante CST, et à écrire le résultat de l'addition dans le registre r0.

Le procédé de la figure 2 comprend une étape initiale 201 (FETCH) de lecture de l'instruction dans le circuit mémoire 150. Pour cela, le microprocesseur applique sur le port d'entrée d'adresses 154 du circuit 150 (via le bus d'adresses 124) l'adresse de l'instruction à lire, déterminée en fonction de la valeur du compteur d'instructions 113. Le microprocesseur applique en même temps un signal de commande en lecture sur le port d'entrée de contrôle 156 du circuit mémoire 150 (via le bus de contrôle 126). L'instruction, codée sous la forme d'une donnée numérique, est alors lue par le microprocesseur sur le port d'entrée/sortie de données 152 du circuit mémoire 150 (via le bus de données 122).

Le procédé de la figure 2 comprend en outre une étape 203 (DECODE) de décodage, par le circuit de décodage d'instructions 111 du microprocesseur, de l'instruction lue à l'étape 201.

Le procédé de la figure 2 comprend en outre une étape 205 (UPDATE_PC) de mise à jour du compteur d'instruction 113, consistant par exemple à incrémenter le compteur 113.

Le procédé de la figure 2 comprend de plus une étape 207 (EXE) d'exécution de l'instruction proprement dite, c'est-à-dire, dans exemple, d'exécution, par l'unité arithmétique et logique 114, de l'addition r1+CST.

Le procédé de la figure 2 comprend de plus une étape 209 (WRITE_BACK) d'écriture du résultat de l'opération dans le registre r0.

La figure 3 est un diagramme illustrant un exemple de procédé de mise en oeuvre d'une opération de stockage en mémoire d'une donnée dans le système de la figure 1. Plus particulièrement, on considère, comme dans l'exemple précédent, que le circuit mémoire interne 112 du microprocesseur 100 comprend deux registres de stockage de données r0 et r1, et on considère à titre illustratif la mise en oeuvre d'une instruction de stockage de donnée de type "store r0, r1" (en langage assembleur), consistant à stocker la valeur contenue dans le registre r1 à l'adresse contenue dans le registre r0.

Le procédé de la figure 3 comprend des étapes initiales 301 (FETCH), 303 (DECODE), 305 (UPDATE_PC) et 307 (EXE) similaires ou identiques aux étapes 201, respectivement 203, respectivement 205, respectivement 207 du procédé de la figure 2. Dans l'exemple de la figure 3, lors de l'étape 307, les valeurs mémorisées dans les registres r0 et r1 sont appliquées respectivement sur le port d'adresse 104 et sur le port de données 102 du microprocesseur. De plus, un signal de commande en écriture est appliqué sur le port de contrôle 106 du microprocesseur.

Le procédé de la figure 3 comprend de plus une étape 309 (ACCESS_MEM) d'accès à la mémoire pour effectivement réaliser l'opération d'écriture dans la mémoire. Lors de cette étape, le microprocesseur applique sur le port d'entrée d'adresses 154 du circuit mémoire 150 (via le bus d'adresses 124) l'adresse stockée dans le registre r0 du circuit mémoire interne 112, applique sur le port d'entrée/sortie de données 152 du circuit mémoire 150 (via le bus de données 122) la donnée contenue dans le registre r1, et applique sur le port d'entrée de contrôle 156 du circuit mémoire 150 (via le bus de contrôle 126) un signal de commande en écriture.

Pour mettre en oeuvre une opération de chargement d'une donnée stockée dans le circuit mémoire, par exemple une opération de type "load r0, r1" (en langage assembleur), consistant à écrire dans le registre r1 la valeur stockée dans le circuit mémoire à l'adresse contenue dans le registre r0, le procédé est similaire à celui de la figure 3, à ceci près que les étapes 307/309 consistent alors en un accès en lecture au circuit mémoire 150. Plus particulièrement, lors de l'étape 309, le microprocesseur applique sur le port d'entrée d'adresses 154 du circuit mémoire 150 (via le bus d'adresses 124) l'adresse stockée dans le registre r0, applique sur le port d'entrée de contrôle 156 du circuit mémoire 150 (via le bus de contrôle 126) un signal de commande en lecture, puis écrit dans le registre r1 la donnée lue sur le port d'entrée/sortie de données 152 du circuit mémoire 150 (via le bus de données 122).

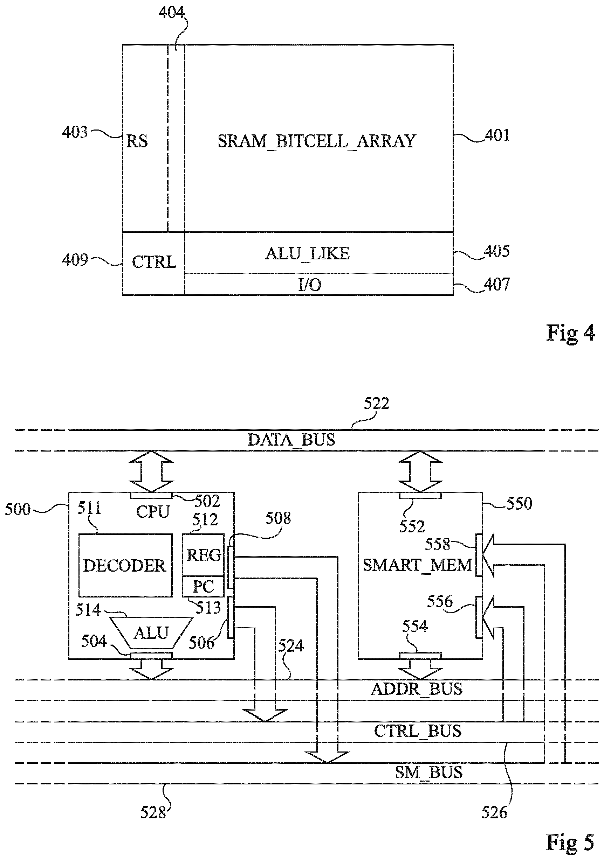

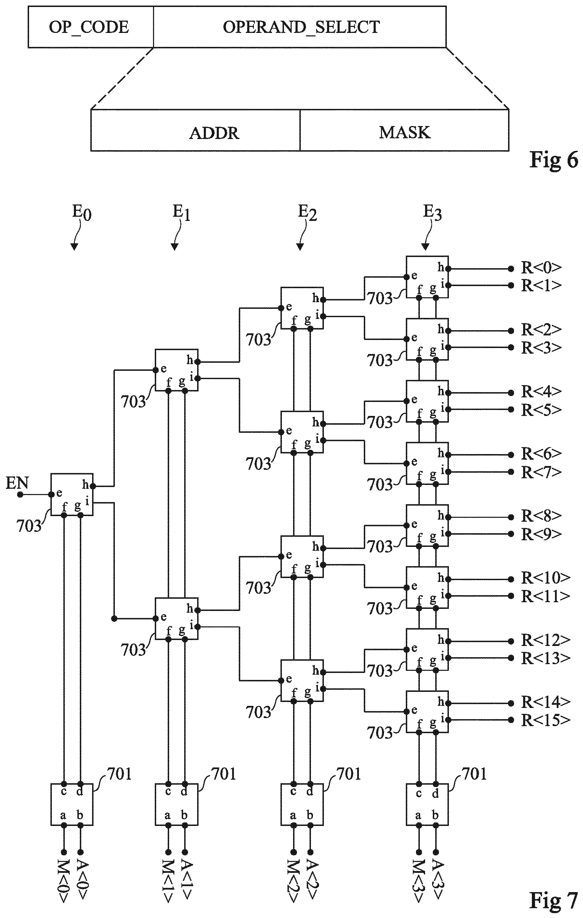

La figure 4 est un schéma très simplifié illustrant, sous forme de blocs fonctionnels, un exemple d'un mode de réalisation d'un circuit mémoire adapté à mettre en oeuvre des opérations de calcul. Le circuit mémoire de la figure 4 comprend une matrice 401 (SRAM_BITCELL_ARRAY) de cellules élémentaires, par exemple des cellules SRAM. A titre d'exemple, la matrice 401 est similaire aux matrices décrites dans la demande de brevet français N°16/54623 susmentionnée. Le circuit mémoire de la figure 4 comprend en outre un circuit de sélection de rangées 403 (RS) adapté à sélectionner une unique rangée de la matrice 401 pour réaliser une opération de lecture ou d'écriture classique, ou à sélectionner simultanément en lecture une ou plusieurs rangées de la matrice 401, de façon à mettre en oeuvre, sur les pistes conductrices de sortie de colonne de la matrice, des opérations logiques de base ayant pour opérandes des données stockées dans les rangées sélectionnées. Le circuit de sélection de rangées 403 peut comprendre un registre spécifique 404 de N bits, où N désigne le nombre de rangées de la matrice 401, adapté à contenir un vecteur de sélection d'opérandes comme cela sera détaillé ci-après en relation avec les figures 6, 7 et 8. Le circuit mémoire de la figure 4 comprend de plus un circuit logique de calcul 405 (ALU_LIKE) adapté à mettre en oeuvre des opérations de calcul supplémentaires à partir des signaux lus sur les pistes conductrices de sortie de colonne de la matrice. Le circuit mémoire de la figure 4 comprend en outre un circuit d'entrée/sortie 407 (I/O) reliant les colonnes de la matrice à des bornes de connexion à l'extérieur du circuit mémoire, par exemple à un port d'entrée/sortie de données (non détaillé sur la figure 4) du circuit mémoire. Le circuit mémoire de la figure 4 comprend en outre un circuit de contrôle 409 (CTRL) relié aux circuits 403, 405 et 407.

La figure 5 est un schéma électrique simplifié d'un exemple d'un mode de réalisation d'un système comportant un microprocesseur 500 (CPU) et un circuit mémoire 550 (SMART_MEM) adapté à mettre en oeuvre des opérations de calcul, par exemple un circuit mémoire du type décrit en relation avec la figure 4. Dans le mode de réalisation de la figure 5, on a cherché à garder une architecture de système la plus proche possible d'une architecture classique telle que décrite en relation avec la figure 1.

Dans cet exemple, le système comprend un bus de données 522 (DATA BUS) qui relie, par exemple connecte, un port d'entrée/sortie de données 502 du microprocesseur 500 à un port d'entrée/sortie de données correspondant 552 du circuit mémoire 550.

Le système comprend de plus un bus d'adresses 524 (ADDR_BUS) qui relie, par exemple connecte, un port de sortie d'adresses 504 du microprocesseur 500 à un port d'entrée d'adresses correspondant 554 du circuit mémoire 550.

Le système comprend en outre un bus de contrôle 526 (CTRL_BUS) qui relie, par exemple connecte, un port de sortie de contrôle 506 du microprocesseur 500 à un port d'entrée de contrôle correspondant 556 du circuit mémoire 550.

Les bus et ports de données, d'adresses et de contrôle du système de la figure 5 sont par exemple identiques ou similaires à ceux du système de la figure 1. Comme cela sera expliqué plus en détail ci-après, l'utilisation de ces bus et ports de données, d'adresses et de contrôle est toutefois différente de l'utilisation classique, de façon à permettre notamment de commander le circuit mémoire pour mettre en oeuvre des opérations de calcul.

Le système de la figure 5 comprend de plus un bus de sélection de mode de fonctionnement 528 (SM_BUS) qui relie, par exemple connecte, un port de sortie de sélection de mode de fonctionnement 508 du microprocesseur 500 à un port d'entrée de sélection de mode de fonctionnement correspondant 558 du circuit mémoire 550.

A titre d'exemple, le bus et les ports de sélection de mode de fonctionnement du système de la figure 5 comportent un unique conducteur (permettant de transmettre un signal binaire unique), ou plusieurs conducteurs parallèles (permettant de transmettre un signal de plusieurs bits en parallèle).

Bien que le bus et les ports de sélection de mode de fonctionnement du système de la figure 5 aient été représentés séparés des bus et ports de données, d'adresses et de contrôle du système, les modes de réalisation décrits ne se limitent pas à cet exemple particulier. En pratique, les bus et ports de sélection de mode de fonctionnement du système de la figure 5 peuvent correspondre à des conducteurs inutilisés des bus et ports de données, d'adresses ou de contrôle du système.

Le microprocesseur 500 comprend un circuit de décodage d'instructions 511 (DECODER), un circuit mémoire interne 512 (REG) comprenant un ou plusieurs registres de stockage temporaire de données, un compteur d'instructions 513 (PC), et une unité arithmétique et logique 514 (ALU). Les circuits 511, 512, 513 et 514 du microprocesseur 500 sont par exemple identiques ou similaires aux circuits 111, respectivement 112, respectivement 113, respectivement 114 du microprocesseur 100 de la figure 1.

Pour lire ou écrire une donnée dans le circuit mémoire 550, le microprocesseur 500 commande le circuit mémoire 550 selon un premier mode de fonctionnement dit classique. Pour cela, le microprocesseur 500 applique un signal de sélection de mode de fonctionnement d'un premier état ou d'une première valeur sur le port d'entrée de sélection de mode de fonctionnement 558 du circuit mémoire (via le port de sortie de sélection de mode de fonctionnement 508 du microprocesseur et le bus de sélection de mode de fonctionnement 528). Les signaux appliqués sur les bus et ports d'adresses, de données et de contrôle sont quant à eux similaires à ce qui a été décrit en relation avec la figure 1. Autrement dit, pour une opération de lecture d'une donnée dans le circuit mémoire, le microprocesseur applique l'adresse de la donnée à lire sur le port d'entrée d'adresses 554 du circuit mémoire (via le port de sortie d'adresses 504 du microprocesseur et le bus d'adresses 524), et applique un signal de commande en lecture sur le port d'entrée de contrôle 556 du circuit mémoire (via le port de sortie de contrôle 506 du microprocesseur et le bus de contrôle 526). Le microprocesseur lit ensuite la donnée correspondante sur le port d'entrée/sortie de données 552 du circuit mémoire (via le bus de données 522 et le port d'entrée/sortie de données 502 du microprocesseur). Pour écrire une donnée dans le circuit mémoire, le microprocesseur applique l'adresse de la zone mémoire à écrire sur le port d'entrée d'adresses 554 du circuit mémoire (via le port de sortie d'adresses 504 du microprocesseur et le bus d'adresses 524), applique la donnée à écrire sur le port d'entrée/sortie de données 552 du circuit mémoire (via le port d'entrée/sortie de données 502 du microprocesseur et le bus de données 522), et applique un signal de commande en écriture sur le port d'entrée de contrôle 556 du circuit mémoire (via le port de sortie de contrôle 506 du microprocesseur et le bus de contrôle 526).

Pour réaliser une opération de calcul directement au sein du circuit mémoire 550, le microprocesseur 500 commande le circuit mémoire selon un deuxième mode de fonctionnement dit intelligent. Pour cela, le microprocesseur applique un signal de sélection de mode de fonctionnement d'un deuxième état ou d'une deuxième valeur sur le port d'entrée de sélection de mode de fonctionnement 558 du circuit mémoire (via le port de sortie de sélection de mode de fonctionnement 508 du microprocesseur et le bus de sélection de mode de fonctionnement 528). Le microprocesseur applique en outre simultanément un signal d'instruction sur le port d'entrée/sortie de données 552 du circuit mémoire (via le port d'entrée/sortie de données 502 du microprocesseur et le bus 522). Le microprocesseur peut en outre appliquer simultanément un signal d'adresse sur le port d'entrée d'adresses 554 du circuit mémoire (via le port de sortie d'adresses 504 du microprocesseur et le bus d'adresses 524), pour indiquer au circuit mémoire à quel emplacement mémoire écrire le résultat de l'opération de calcul.

Le circuit de contrôle interne du circuit mémoire 550 (le circuit 409 de la figure 4) est adapté à lire le signal de sélection de mode appliqué sur le port d'entrée de sélection de mode 558 du circuit mémoire.

Lorsque le signal de sélection de mode de fonctionnement est dans le premier état, correspondant au mode de fonctionnement classique du circuit mémoire, le circuit de contrôle interne du circuit mémoire interprète les signaux appliqués sur les bus et ports d'adresses, de données et de contrôle comme des signaux de commande classique. Plus particulièrement, le signal d'adresse appliqué sur le port d'entrée d'adresses 554 est lu et décodé (par le circuit de contrôle et/ou le circuit de sélection de rangées), et la rangée correspondante est activée de façon à mettre en oeuvre l'opération de lecture ou d'écriture requise.

Lorsque le signal de sélection de mode de fonctionnement est dans le deuxième état, correspondant au mode de fonctionnement intelligent du circuit mémoire, le circuit de contrôle interne du circuit mémoire interprète le signal appliqué sur le port d'entrée/sortie de données du circuit mémoire comme un signal d'instruction indiquant au circuit mémoire quelle opération de calcul exécuter et dans quelles rangées du circuit mémoire se situent les opérandes de ce calcul. Le signal d'instruction est lu et décodé (par le circuit de contrôle et le circuit de sélection de rangées), et les rangées correspondantes sont activées en lecture de façon à mettre en oeuvre l'opération de calcul requise. Le résultat de l'opération de calcul peut être réécrit directement dans le circuit mémoire 550 (sans repasser par le circuit mémoire interne du microprocesseur), à l'adresse indiquée sur le port d'entrée d'adresses 554 du circuit mémoire.

Un avantage du système de la figure 5 est qu'il permet de réaliser des accès classiques au circuit mémoire 550, par exemple en vue de réaliser des opérations de calcul conventionnelles au moyen de l'unité arithmétique et logique 504 du microprocesseur 500, et des accès intelligents au circuit mémoire 550, en vue de réaliser des opérations de calcul directement au sein du circuit mémoire 550 de façon à soulager l'unité arithmétique et logique 504 du microprocesseur et limiter les échanges de données entre le circuit mémoire 550 et le microprocesseur 500.
la figure 6 illustre schématiquement un exemple de format d'un signal d'instruction utilisé par le microprocesseur 500 du système de la figure 5, pour commander la mise en oeuvre d'une opération de calcul par le circuit mémoire 550 du système.

Le signal d'instructions représenté en figure 6 est un signal sur plusieurs bits appliqué par le microprocesseur sur le port d'entrée/sortie de données 552 du circuit mémoire 550.

Ce signal d'instruction comprend un premier champ OP_CODE sur un ou plusieurs bits, définissant le type d'opération logique ou arithmétique à réaliser au sein du circuit mémoire.

Le signal d'instruction comprend en outre un deuxième champ OPERAND_SELECT sur plusieurs bits, définissant les adresses des rangées contenant les opérandes de l'opération à réaliser.

On notera qu'une opération de calcul mise en oeuvre au sein du circuit mémoire peut comporter un nombre d'opérandes élevé, par exemple supérieur à deux, et pouvant aller jusqu'au nombre total de rangées du circuit mémoire. Un problème qui se pose est celui de l'adressage des données opérandes. En effet, dans un circuit mémoire classique de N rangées, où N est un entier supérieur ou égal à 2 (par exemple une puissance de 2), le circuit de contrôle comprend généralement un décodeur d'adresse de rangée unique adapté à recevoir une adresse codée sur log₂(N) bits, et à activer la rangée correspondante en vue d'une opération de lecture ou d'écriture dans cette rangée. Pour permettre d'activer simultanément en lecture K rangées distinctes de la matrice de façon à réaliser une opération logique à K opérandes, où K est un entier supérieur ou égal à 2, une possibilité serait de répliquer K fois le décodeur d'adresse de rangée, de façon à pouvoir transmettre simultanément les K adresses d'opérandes au circuit de contrôle lors de la mise en oeuvre d'une opération de calcul. Cette solution implique toutefois une augmentation importante de la surface et de la consommation énergétique du circuit mémoire, et n'est en pratique pas compatible avec les dimensions usuelles des bus reliant un circuit mémoire à un microprocesseur, notamment lorsque le nombre d'opérandes K est important (par exemple K = N) .

Ainsi, dans un mode de réalisation préféré, le champ OPERAND_SELCT du signal d'instruction de la figure 6 définit, sous forme codée, un vecteur de sélection d'opérandes permettant d'identifier les rangées à sélectionner lors de la mise en oeuvre de l'opération de calcul. Le vecteur de sélection d'opérandes comprend par exemple N bits, où N est le nombre de rangées du circuit mémoire. Le vecteur de sélection d'opérandes est utilisé comme masque de sélection pour activer simultanément en lecture une pluralité de rangées du circuit mémoire lors de la mise en oeuvre de l'opération de calcul. A titre d'exemple, pour chaque bit du vecteur de sélection d'opérandes, la rangée correspondante du circuit mémoire est activée en lecture si le bit correspondant du vecteur de sélection d'opérandes est à la valeur binaire '1', et n'est pas activée en lecture si le bit correspondant du vecteur de sélection d'opérandes est à la valeur binaire '0'.

A titre d'exemple, le champ OPERAND_SELCT contient deux sous-champs ADDR et MASK de log₂(N) bits chacun, dont la combinaison définit un vecteur de sélection d'opérandes de N bits.

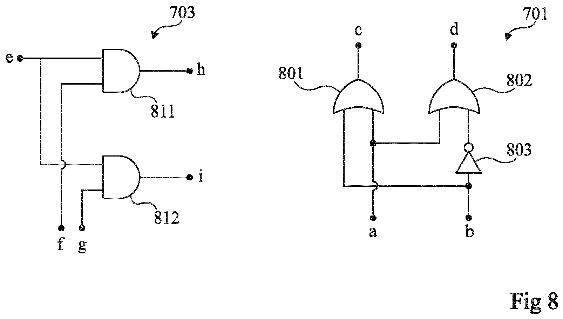

Le décodage du champ OPERAND_SELECT peut être réalisé au sein du circuit mémoire, par exemple par le circuit de sélection de rangées du circuit mémoire. Une fois décodé, le vecteur de sélection de rangées peut être stocké dans un registre spécifique du circuit mémoire en vue d'activer en lecture les rangées sélectionnées lors de la mise en oeuvre de l'opération de calcul proprement dite. Un exemple de réalisation d'un circuit de décodage adapté à générer un vecteur de sélection d'opérandes à partir du champ OPERAND_SELECT va maintenant être décrit en relation avec les figures 7 et 8.

La figure 7 est un schéma électrique simplifié d'un exemple de réalisation d'un circuit de sélection de rangées d'un circuit mémoire adapté à mettre en oeuvre des opérations de calcul (par exemple le circuit de sélection de rangées 403 de la figure 4).

On considère dans cet exemple un nombre N de rangées sélectionnables égal à 16, étant entendu que l'homme du métier saura adapter le circuit décrit à un nombre de rangées différent.

Le circuit de la figure 7 comprend des premières cellules logiques de sélection élémentaires 701 à deux entrées a et b et deux sorties c et d chacune, et des deuxièmes cellules logiques de sélection élémentaires 703 à trois entrées e, f et g et deux sorties h et i chacune.

Plus particulièrement, le circuit de la figure 7 comprend Q=log₂(N) étages Eⱼ, avec j entier allant de 0 à Q-1 (Q=4 dans cet exemple), chaque étage Eⱼ comprenant une cellule 701 et 2^{j} cellules 703.

Dans chaque étage Eⱼ, chaque cellule 703 de l'étage a ses noeuds d'entrée f et g connectés respectivement aux noeuds de sortie c et d de la cellule 701 de l'étage.

De plus, dans chaque étage Eⱼ à l'exception de l'étage E_{Q-1}, chaque cellule 703 de l'étage a son noeud de sortie h connecté au noeud d'entrée e de l'une des cellules 703 de l'étage Eⱼ₊₁ et son noeud de sortie i connecté au noeud d'entrée e d'une autre des cellules 703 de l'étage Eⱼ₊₁, étant entendu que :
- dans chaque étage Eⱼ à l'exception de l'étage E_{Q-1}, chaque cellule 703 de l'étage a son noeud de sortie h connecté au noeud d'entrée e d'une et d'une seule cellule 703 de l'étage Eⱼ₊₁ et a son noeud de sortie i connecté au noeud d'entrée e d'une et une seule cellule 703 de l'étage Eⱼ₊₁ ; et
- dans chaque étage Eⱼ à l'exception de l'étage E₀, chacune des cellules 703 de l'étage a son noeud d'entrée e connecté à un et un seul noeud de sortie h ou i d'une cellule 703 de l'étage Eⱼ₋₁.

La table de vérité des cellules 701 est la suivante (en désignant les signaux logiques d'entrée et de sortie d'une cellule 701 par les mêmes références que les bornes d'entrée et de sortie correspondantes de la cellule) :

| a | b | c | d |
|---|---|---|---|
| 0 | 0 | 0 | 1 |
| 0 | 1 | 1 | 0 |
| 1 | 0 | 1 | 1 |
| 1 | 1 | 1 | 1 |

La table de vérité des cellules 703 est la suivante (en désignant les signaux logiques d'entrée et de sortie d'une cellule 703 par les mêmes références que les bornes d'entrée et de sortie correspondantes de la cellule) :

| e | f | g | h | i |
|---|---|---|---|---|
| 0 | 0 | 0 | 0 | 0 |
| 0 | 0 | 1 | 0 | 0 |
| 0 | 1 | 0 | 0 | 0 |
| 0 | 1 | 1 | 0 | 0 |
| 1 | 0 | 0 | 0 | 0 |
| 1 | 0 | 1 | 0 | 1 |
| 1 | 1 | 0 | 1 | 0 |
| 1 | 1 | 1 | 1 | 1 |

Le fonctionnement du circuit de la figure 7 est le suivant.

Lors de la mise en oeuvre d'une opération de calcul au sein du circuit mémoire, les Q=log₂(N) bits du sous-champ MASK du champ OPERAND _SELECT du signal d'instruction sont appliqués respectivement, en parallèle, sur les bornes d'entrée a des cellules 701 des étages E₀ à E_{Q-1} du circuit de sélection de rangées. De plus, les Q=log₂(N) bits du sous-champ ADDR du champ OPERAND_SELECT du signal d'instruction sont appliqués respectivement, en parallèle, sur les bornes d'entrée b des cellules 701 des étages E₀ à E_{Q-1} du circuit de sélection de rangées. Un signal d'activation EN à l'état logique 1 est en outre appliqué sur la borne d'entrée e de la cellule 703 de l'étage E₀. Les signaux logiques de sortie fournis sur les bornes h et i des 2^{Q-1} cellules 703 de l'étage E_{Q-1} correspondent respectivement aux N bits R<0>, R<1>, ... R<N-1> d'un vecteur de sélection de rangées R utilisé pour décider d'activer ou non en lecture chacune des N rangées de la matrice lors de la mise en oeuvre de l'opération de calcul.

La figure 8 illustre plus en détail un exemple de réalisation d'une cellule élémentaire 701 (en partie droite de la figure 8) du circuit de la figure 7, et un exemple de réalisation d'une cellule élémentaire 703 (en partie gauche de la figure 8) du circuit de la figure 7.

Dans cet exemple, la cellule 701 comprend deux portes logiques OU 801 et 802 à deux entrées et un sortie chacune. La porte OU 801 a une première entrée connectée au noeud d'entrée a de la cellule et une deuxième entrée connectée au noeud d'entrée b de la cellule. La porte OU 802 a quant à elle une première entrée connecté au noeud d'entrée a de la cellule et une deuxième entrée reliée au noeud d'entrée b de la cellule par l'intermédiaire d'un inverseur 803. Le noeud de sortie de la porte OU 801 est connectée au noeud de sortie c de la cellule, et le noeud de sortie de la porte OU 802 est connecté au noeud de sortie d de la cellule.

Dans cet exemple, la cellule 703 comprend deux portes logiques ET 811 et 812 à deux entrées et une sortie chacune. La porte ET 811 a une première entrée connectée au noeud d'entrée e de la cellule et une deuxième entrée connectée au noeud d'entrée f de la cellule. La porte ET 812 a quant à elle une première entrée connectée au noeud d'entrée e de la cellule et une deuxième entrée connectée au noeud d'entrée g de la cellule. Le noeud de sortie de la porte ET 811 est connecté au noeud de sortie h de la cellule, et le noeud de sortie de la porte ET 812 est connecté au noeud de sortie i de la cellule.

De façon avantageuse, lors de la mise en oeuvre d'une opération de calcul au sein du circuit mémoire 550, la préparation des signaux de commande du circuit mémoire 550 et la transmission de ces signaux de commande au circuit mémoire 550 peuvent être réalisées en utilisant uniquement le jeu d'instructions classique du microprocesseur 550. Ceci est rendu possible par le fait que les signaux de commande du circuit mémoire 550 en mode intelligent transitent par les mêmes bus de données, d'adresses et de contrôle que les signaux de commande du circuit mémoire 550 en mode classique.

A titre d'exemple, pour transmettre au circuit mémoire 550 les signaux de commande nécessaires à la mise en oeuvre d'une opération de calcul au sein du circuit mémoire 550, on peut prévoir d'utiliser une instruction de type "store r0, r1" (en langage assembleur), classiquement utilisée pour stocker la valeur contenue dans le registre r1 à l'adresse du circuit mémoire contenue dans le registre r0. Avant l'exécution de l'instruction "store" proprement dite, on prévoit des étapes initiales de préparation des registres r0 et r1 du microprocesseur pour écrire respectivement, dans le registre r1, le signal d'instruction définissant l'opération de calcul à réaliser au sein du circuit mémoire 550, par exemple au format décrit en relation avec la figure 6, et, dans le registre r0, l'adresse à laquelle écrire le résultat de l'opération de calcul.

Un avantage de ce mode de fonctionnement réside dans sa compatibilité avec les microprocesseurs existants.

A titre de première variante, pour mettre en oeuvre une opération de calcul au sein du circuit mémoire 550, la préparation des signaux de commande du circuit mémoire 550 et la transmission de ces signaux de commande au circuit mémoire 550 peuvent être réalisées en utilisant une instruction spécifique, venant s'ajouter au jeu d'instructions classique du microprocesseur 550.

A titre de deuxième variante, pour mettre en oeuvre une opération de calcul au sein du circuit mémoire 550, la préparation des signaux de commande du circuit mémoire 550 et la transmission de ces signaux de commande au circuit mémoire 550 peuvent être réalisées en utilisant un jeu d'instructions spécifique, comprenant par exemple une instruction spécifique par type d'opération de calcul réalisable au sein du circuit mémoire, le jeu d'instructions spécifique venant s'ajouter au jeu d'instructions classique du microprocesseur 550.

Les première et deuxième variantes susmentionnées ont pour avantage de faciliter le travail de compilation d'un code source en une suite d'instructions exécutable par le microprocesseur. Toutefois, un inconvénient de ces variantes réside dans leur incompatibilité avec les microprocesseurs ne reconnaissant pas les instructions spécifiques au mode de fonctionnement intelligent du circuit mémoire.

Comme expliqué ci-dessus, un avantage du système de la figure 5 est qu'il permet de réaliser des accès classiques au circuit mémoire 550, par exemple en vue de réaliser des opérations de calcul conventionnelles au moyen de l'unité arithmétique et logique 504 du microprocesseur 500, et des accès intelligents au circuit mémoire 550, en vue de réaliser des opérations de calcul directement au sein du circuit mémoire 550.

Lors de la programmation d'un logiciel destiné à être exécuté dans un tel système, le programmeur pourra tirer profit de ces deux modes de fonctionnement. A titre d'exemple, il pourra choisir de sa propre initiative, pour chaque opération de calcul, s'il souhaite que l'opération soit réalisée de façon conventionnelle par l'unité arithmétique et logique du microprocesseur, ou s'il souhaite que l'opération soit réalisée au sein du circuit mémoire. A titre de variante, ce choix peut être réalisé de façon automatique par un logiciel de compilation de code source, de façon à optimiser la vitesse d'exécution du programme et/ou la consommation électrique du système. Dans ce dernier cas, le programmeur peut utiliser un langage de programmation classique, ne permettant pas de choisir directement le mode de fonctionnement souhaité pour chaque opération.

Un avantage du système proposé est que des accès classiques au circuit mémoire 550 et des accès intelligents au circuit mémoire 550 peuvent être exécutés de façon entrelacée. On notera que, dans le mode de fonctionnement intelligent, certaines instructions envoyées par le microprocesseur 500 au circuit mémoire 550 peuvent prendre plusieurs cycles d'horloge du microprocesseur 500 pour être exécutées par le circuit mémoire 550. Lorsqu'une telle instruction est en cours d'exécution par le circuit mémoire 500, d'autres instructions classiques ou intelligentes peuvent être transmises au circuit mémoire 550 et exécutées en parallèle par le circuit mémoire 550, par exemple lorsqu'elles concernent des rangées différentes du circuit mémoire 550 et/ou lorsque la mémoire est une mémoire multiports, et/ou lors de cycles au cours desquels la mémoire 550 n'est pas lue ou écrite dans le cadre de l'exécution de l'instruction intelligente. A titre d'exemple, les instructions transmises par le microprocesseur 500 au circuit mémoire 550 peuvent être pipelinées de façon à envoyer une instruction classique ou intelligente au circuit mémoire 550 à chaque cycle d'horloge du microprocesseur 500.

Des modes de réalisation particuliers ont été décrits. Diverses variantes et modifications apparaîtront à l'homme de l'art. En particulier, le mode de fonctionnement intelligent du circuit mémoire peut être utilisé pour réaliser des opérations autres que des opérations de calcul. A titre d'exemple, le mode de fonctionnement intelligent du circuit mémoire peut être utilisé pour réaliser une écriture simultanée d'une même donnée dans plusieurs rangées de la mémoire. Dans ce cas, les rangées à écrire peuvent être sélectionnées au moyen d'un vecteur de sélection de rangées codé selon le format de codage décrit en relation avec les figures 6, 7 et 8.

Par ailleurs, les modes de réalisation décrits ne se limitent pas à l'exemple de format de signal d'instruction décrit en relation avec les figures 6, 7 et 8 pour commander le circuit mémoire dans le mode de fonctionnement intelligent. En particulier, dans le cas d'une opération nécessitant la sélection d'un nombre limité de rangées, par exemple une opération nécessitant la sélection de deux rangées seulement (par exemple une opération de calcul à deux opérandes ou une opération d'écriture simultanée d'une même donnée dans deux rangées du circuit mémoire), on pourra prévoir de transmettre les adresses complètes des rangées à sélectionner directement sur le bus de données, sans passer par un codage au moyen d'un vecteur de sélection d'opérandes, et ainsi gagner au moins un cycle d'horloge pour la mise en oeuvre de l'opération. Le cas échéant, une ou plusieurs adresses de rangées à sélectionner supplémentaires peuvent être transmises via le bus d'adresses.

En outre, les modes de réalisation décrits ne se limitent pas à l'exemple de circuit de sélection de rangées décrit en relation avec les figures 7 et 8.

## Revendications

**1.** Circuit mémoire (550) comportant :
une pluralité de cellules élémentaires de stockage agencées en matrice selon des rangées et des colonnes ;
un port d'entrée/sortie de données (552) ;
un port d'entrée d'adresses distinct du port d'entrée/sortie de données (554) ;
un port d'entrée de sélection de mode (558) ; et
un circuit interne de commande configuré pour :
lire un signal de sélection de mode appliqué sur le port de sélection de mode (558) ;
lorsque le signal de sélection de mode est à un premier état, lire une adresse d'une rangée sur le port d'entrée d'adresses (554) et mettre en oeuvre, via le port d'entrée/sortie de données (552), une opération de lecture ou d'écriture dans cette rangée ; et
lorsque le signal de sélection de mode est à un deuxième état, lire sur le port d'entrée/sortie de données (552) un signal d'instruction et mettre en oeuvre une opération comprenant l'activation simultanée en lecture ou en écriture d'au moins deux rangées sélectionnées en fonction du signal d'instruction,
dans lequel le signal d'instruction comprend un premier champ (OP_CODE) définissant un type d'opération à mettre en oeuvre par le circuit interne de commande.

**2.** Circuit mémoire (550) selon la revendication 1, dans lequel le circuit interne de commande est adapté à, lorsque le signal de sélection de mode est au deuxième état, mettre en oeuvre une opération de calcul comprenant l'activation simultanée en lecture d'au moins deux rangées sélectionnées en fonction du signal d'instruction.

**3.** Circuit mémoire (550) selon la revendication 2, dans lequel le circuit interne de commande est en outre configuré pour, lorsque le signal de sélection de mode est au deuxième état, lire un signal d'adresse sur le port d'entrée d'adresses (554) et écrire à l'adresse correspondante du circuit mémoire un résultat de l'opération de calcul.

**4.** Circuit mémoire (550) selon la revendication 1, dans lequel le circuit interne de commande est adapté à, lorsque le signal de sélection de mode est au deuxième état, mettre en oeuvre une opération d'écriture d'une même donnée dans au moins deux rangées sélectionnées en fonction du signal d'instruction.

**5.** Circuit mémoire (550) selon l'une quelconque des revendications 1 à 4, dans lequel le signal d'instruction comprend un deuxième champ (OPERAND SELECT) définissant les adresses des rangées à sélectionner pour la mise en oeuvre de l'opération.

**6.** Circuit mémoire (550) selon la revendication 5, comportant en outre un circuit de sélection de rangées configuré pour générer, à partir du deuxième champ (OPERAND_SELECT) du signal d'instruction, un vecteur de sélection de rangées (R) de N bits, où N est un entier désignant le nombre de rangées de la matrice.

**67.** Circuit mémoire (550) selon la revendication 6, dans lequel le deuxième champ (OPERAND_SELECT) comprend un premier sous-champ (ADDR) et un deuxième sous-champ (MASK) de log₂(N) bits chacun, où N est un entier désignant le nombre de rangées de la matrice.

**8.** Circuit mémoire (550) selon la revendication 7, dans lequel le circuit de sélection de rangées est adapté à générer le vecteur de sélection de rangées (R) à partir des premier (ADDR) et deuxième (MASK) sous-champs du deuxième champ (OPERAND_SELECT) du signal d'instruction.

**9.** Circuit mémoire (550) selon la revendication 8, dans lequel le circuit de sélection de rangées comprend Q=log₂(N) étages Eⱼ, avec j entier allant de 0 à Q-1, chaque étage Eⱼ comprenant une première cellule logique de sélection (701) comprenant des premier (a) et deuxième (b) noeuds d'entrée et des premier (c) et deuxième (d) noeuds de sortie, et 2^{j} deuxièmes cellules logiques de sélection (703) comprenant chacune des premier (e), deuxième (f) et troisième (g) noeuds d'entrée et des premier (h) et deuxième (i) noeuds de sortie.

**10.** Circuit mémoire (550) selon la revendication 9, dans lequel :
dans chaque étage Eⱼ, chaque deuxième cellule (703) de l'étage a ses deuxième (f) et troisième (g) noeuds d'entrée connectés respectivement aux premier (c) et deuxième (d) noeuds de sortie de la première cellule (701) de l'étage ; et
dans chaque étage Eⱼ à l'exception de l'étage E_{Q-1}, chaque deuxième cellule (703) de l'étage a son premier noeud de sortie (h) connecté au premier noeud d'entrée (e) de l'une des deuxièmes cellules (703) de l'étage Eⱼ₊₁ et son deuxième noeud de sortie (i) connecté au premier noeud d'entrée (e) d'une autre des deuxièmes cellules (703) de l'étage Eⱼ₊₁.

**11.** Circuit mémoire (550) selon la revendication 9 ou 10, dans lequel :
chaque première cellule (701) comprend des première (801) et deuxième (802) portes logiques OU, la première porte OU (801) ayant une première entrée connectée au premier noeud d'entrée (a) de la cellule, une deuxième entrée connectée au deuxième noeud d'entrée (b) de la cellule, et une sortie connectée au premier noeud de sortie (c) de la cellule, et la deuxième porte OU (802) ayant une première entrée connecté au premier noeud d'entrée (a) de la cellule, une deuxième entrée reliée au deuxième noeud d'entrée (b) de la cellule par l'intermédiaire d'un inverseur (803), et une sortie connectée au deuxième noeud de sortie (d) de la cellule ; et
chaque deuxième cellule (703) comprend des première (811) et deuxième (812) portes logiques ET, la première porte ET (811) ayant une première entrée connectée au premier noeud d'entrée (e) de la cellule, une deuxième entrée connectée au deuxième noeud d'entrée (f) de la cellule, et une sortie connectée au premier noeud de sortie (h) de la cellule, et la deuxième porte ET (812) ayant une première entrée connectée au premier noeud d'entrée (e) de la cellule, une deuxième entrée connectée au troisième noeud d'entrée (g) de la cellule, et une sortie connectée au deuxième noeud de sortie (i) de la cellule.

**12.** Circuit mémoire (550) selon l'une quelconque des revendications 9 à 11, dans lequel le circuit interne de commande est configuré pour, lorsque le signal de sélection de mode est au deuxième état, appliquer les log₂(N) bits du premier sous-champ (A) respectivement sur les log₂(N) deuxièmes noeuds d'entrée (b) des premières cellules (701) du circuit de sélection de rangées, et appliquer les log2(N) bits du deuxième sous-champ (B) respectivement sur les log₂(N) premiers noeuds d'entrée (a) des premières cellules (701) du circuit de sélection de rangées.

**13.** Système comportant un microprocesseur (500) et un circuit mémoire (550) selon l'une quelconque des revendications 1 à 12, le système comportant en outre :
un bus de données (522) reliant un port d'entrée/sortie de données (502) du microprocesseur au port d'entrée/sortie de données (552) du circuit mémoire ;
un bus d'adresses (524) reliant un port de sortie d'adresses (504) du microprocesseur au port d'entrée d'adresses (554) du circuit mémoire ; et
un bus de sélection de mode (528) reliant un port de sortie de sélection de mode (508) du microprocesseur au port d'entrée de sélection de mode (558) du circuit mémoire.

**14.** Système selon la revendication 13, dans lequel le microprocesseur est configuré pour :
dans un premier mode de fonctionnement :
- appliquer un signal de sélection de mode au premier état sur le bus de sélection de mode (528) ;
- appliquer un signal d'adresse de rangée sur le bus d'adresses (524) ; et
- lire ou écrire une donnée dans la rangée correspondante du circuit mémoire via le bus de données (522), et
dans un deuxième mode de fonctionnement :
- appliquer un signal de sélection de mode au deuxième état sur le bus de sélection de mode (528) ; et
- appliquer un signal d'instruction sur le bus de données (522).
